## Europäisches Patentamt

## European Patent Office

## Office européen des brevets

(19)

(11) Veröffentlichungsnummer: **0 002 211**
**B1**

(12) **EUROPÄISCHE PATENTSCHRIFT**

(45) Veröffentlichungstag der Patentschrift:
**12.08.81**

(21) Anmeldenummer: **78101390.9**

(22) Anmeldetag: **17.11.78**

(51) Int. Cl.³: **G 01 R 1/20, H 01 R 17/20**

(54) **Elektrisches Kupplungsstück.**

(30) Priorität: **29.11.77 CH 14573/77**

(43) Veröffentlichungstag der Anmeldung:
**13.06.79 Patentblatt 79/12**

(45) Bekanntmachung des Hinweises auf die Patenterteilung:
**12.08.81 Patentblatt 81/32**

(84) Benannte Vertragsstaaten:
**CH DE FR GB NL**

(56) Entgegenhaltungen:
**DE-C-520 236**
**GB-A-1 159 999**
**US-A-2 489 037**
**US-A-2 605 318**

(73) Patentinhaber: **CONTRAVES GmbH,**
**Hans-Stiessberger-Strasse 2a, D-8013 Haar (DE)**

(72) Erfinder: **Spannehl, Hans-Peter, Eschenweg 17,**
**D-7752 Reichenau 2 (DE)**

(74) Vertreter: **Althoff, Gerhard et al, Patentanwälte**
**Mitscherlich, Gunschmann Dr. Körber, Schmidt-Evers**
**Steinsdorfstrasse 10, D-8000 München 22 (DE)**

BUNDESDRUCKEREI BERLIN

## Elektrisches Kupplungsstück

Die Erfindung betrifft ein elektrisches Kupplungsstück, welches ein erstes und ein zweites Kontaktorgan aufweist und in ein mit im Abstand zueinander angeordneten Kontaktelementen versehenes Buchsenteil eines Sicherungshalters einsteck- und arretierbar ist, wobei in gekuppeltem Zustand die Kontaktorgane des Kupplungsstückes die zugeordneten Kontaktelemente des Buchsenteils kontaktieren.

Der Erfindung liegt die Aufgabe zugrunde, unter Verwendung eines mit mindestens zwei Kontaktelementen versehenen, an sich bekannten Buchsenteils eines Sicherungshalters ein in das Buchsenteil einsteck- und arretierbares, elektrisches Kupplungsstück zu schaffen, mittels welchem die an den Kontaktelementen anliegenden Eingangsgrößen elektrischer Ströme und Spannungen abgetastet und auf ein entsprechendes Meßgerät übertragen werden können.

Diese Aufgabe wird erfindungsgemäß dadurch gelöst, daß das erste Kontaktorgan für die ersten Kontaktelemente an dem einen Ende eines in dem Kupplungsstück koaxial angeordneten Stößel befestigt ist, daß mehrere zweite Kontaktorgane vorhanden sind und die zweiten Kontaktorgane für die zweiten Kontaktelemente an dem einen Ende einer durch eine Isolierhülse von dem Stößel getrennten Kupplungshülse angeformt sind, daß die Kontaktorgane durch die Kraft einer einzigen Druckfeder gegen die zugeordneten Kontaktelemente gepreßt werden, und daß am jeweiligen anderen Ende des Stößels und der Kupplungshülse mindestens ein jeweils in einer Ausnehmung eines Kopfstücks angeordneter elektrischer Anschluß befestigt ist.

Durch die Merkmale der Erfindung können die im Buchsenteil eines Sicherungshalters eng beieinanderliegenden und nicht ohne besonderen Aufwand zugänglichen Kontaktelemente in einem Vorgang mit relativ geringem Übergangswiderstand direkt abgetastet und auf ein entsprechendes Meßgerät übertragen werden, wobei die ermittelten Meßwerte nahezu unverfälscht den tatsächlichen Eingangsgrößen am Buchsenteil entsprechen. Ein weiterer Vorteil des Kupplungsstückes liegt darin, daß beispielsweise die in einer Geräte-Einheit aus baulichen oder technischen Gründen an nicht gut sichtbarer oder zugänglicher Stelle angeordneten und in einem Sicherungshalter eingesetzten Anzeigelampen, welche eine defekte Sicherung signalisieren, mittels des Kupplungsstücks ohne besonderen Aufwand an eine gut sichtbare und zugängliche Stelle der Geräte-Einheit verlegt werden können. Das Kupplungsstück eignet sich einerseits zum Messen von elektrischen Strömen und Spannungen in Gerätesicherungsbuchsen und andererseits zum Verlegen von in einem Sicherungshalter eingesetzten Anzeigelampen.

Die Erfindung wird nachstehend an Hand eines Ausführungsbeispiels in Verbindung mit der Zeichnung beschrieben. Es zeigt

Fig. 1 ein in Ansicht und in größerem Maßstab dargestelltes Kupplungsstück,

Fig. 2 ein im Längsschnitt dargestelltes Buchsenteil eines Sicherungshalters für das Kupplungsstück,

Fig. 3 das im Längsschnitt dargestellte Buchsenteil mit eingesetztem, ebenfalls im Schnitt dargestellten Kupplungsstück, und

Fig. 4 einen Schnitt gemäß der Linie IV-IV in Fig. 3.

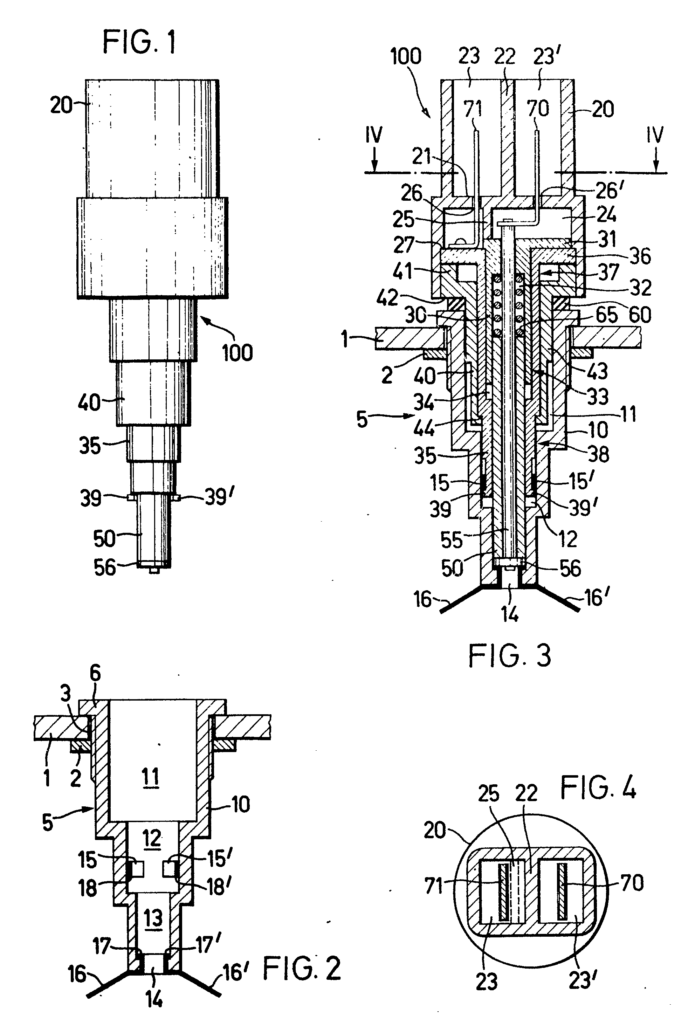

In Fig. 1 ist in Ansicht ein Kupplungsstück 100 dargestellt, welches einerseits zum Abgreifen elektrischer Ströme und Spannungen und andererseits zum örtlichen Verlegen von in Geräte-Einheiten eingebauten Sicherungen verwendbar und ausgebildet ist, und man erkennt ein Kopfstück 20, eine zylindrische Kupplungshülse 35 mit angeformten Kontakt- bzw. Haltenocken 39, 39', eine zylindrische Haube 40 sowie eine rohrförmige Isolierhülse 50.

In Fig. 2 ist ein handelsübliches, durch eine Öffnung 3 eines Geräteteils 1 hindurchgeführtes und mit einem ringförmigen Flansch 6 am Geräteteil anliegendes durch nicht näher dargestellte Befestigungsmittel 2 gehaltenes Buchsenteil 5 dargestellt. Das Buchsenteil 5 umfaßt ein stufenförmig abgesetztes und im wesentlichen zylindrisch ausgebildetes Gehäuse 10 mit zylindrischen Ausnehmungen 11, 12, 13 und 14. Auf der dem Flansch 6 gegenüberliegenden Seite ist am Gehäuse 10 mindestens ein, im dargestellten Beispiel jedoch zwei, durch die Ausnehmung 14 hindurchgeführte und mit nicht näher dargestellten Mitteln mit dem Gehäuse fest verbundene erste Kontaktelemente 16, 16' vorgesehen. In der Ausnehmung 12 sind ferner zwei mit nicht näher dargestellten Mitteln mit dem Gehäuse fest verbundene zweite Kontaktelemente 15, 15' angeordnet. Die Kontaktelemente 16, 16' weisen in der Ausnehmung 13 eine Kontaktfläche 17, 17' auf, während die Kontaktelemente 15, 15' segmentartig in der Ausnehmung 12 angeordnet und mit ringförmigen Kontaktflächen 18, 18' ausgebildet sind.

In Fig. 3 ist im Längsschnitt das Buchsenteil 5 mit eingesetztem Kupplungsstück dargestellt, welches nachstehend näher beschrieben wird. Das Kupplungsstück 100 umfaßt im wesentlichen das Kopfstück 20, eine zylindrische Federhülse 30, die Kupplungshülse 35 mit angeformten Kontaktorganen 39, 39', die Haube 40, die Isolierhülse 50 sowie einen im Kupplungsstück koaxial angeordneten Stößel 55.

Das mit einem Boden 21 und Steg 25 versehene Kopfstück 20 weist auf der einen Seite des Bodenteils 21 zwei durch einen Steg 22 voneinander getrennte Ausnehmungen 23, 23' und auf der anderen Seite des Bodens eine im wesentlichen zylindrische, abgesetzte und mit einer Anlagekante 27 versehene Ausnehmung 24 auf. In dem Boden 21 sind ferner zwei im Abstand zueinander, vorzugsweise in der jeweiligen Mitte der Ausnehmungen 23, 23' angeordnete, schlitzartig ausgebildete Öffnungen 26, 26' vorgesehen. Die Ausnehmung 24 des Kopfstückes 20 dient zur Aufnahme und Zentrierung eines an der Federhülse 30 angeformten und am Steg 25 anliegenden Flansches 31, eines an der Kupplungshülse 35 angeformten und an der Kante 27 anliegenden Flansches 36 sowie einer an der Haube 40 angeformten Ringfläche 41.

Die Haube 40 ist mit dem einen, die Ringfläche 41 aufweisenden Ende in dem Kopfstück 20 sowie mit einem weiteren zylindrischen Teil 43 in der Ausnehmung 11 des Gehäuses 10 geführt und weist am anderen, der Ringfläche gegenüberliegenden Ende eine radial nach innen gerichtete Anlagekante 44 auf, welche als Einschubbegrenzung für die Kupplungshülse dient.

Die auf der einen Seite mit dem Flansch 36 in der Ausnehmung 24 des Kopfstückes 20 geführte Kupplungshülse 35 ist mit einem zylindrischen Teil 37 bis zur Anlagekante 44 der Haube 40 eingeschoben und mit einem weiteren zylindrischen Teil 38 in der Ausnehmung 12 des Gehäuses 10 geführt. Am anderen Ende weist die Kupplungshülse mindestens zwei radial nach außen gerichtete, die zweiten Kontaktorgane bildende Anschlagnocken 39, 39' auf, welche im zusammengebauten Zustand gemäß Fig. 3 hinter die segmentartig angeordneten Kontaktelemente 15, 15' greifen und an den Kontaktflächen 18, 18' anliegen.

Die Kupplungshülse 35 weist zur Aufnahme eines im wesentlichen zylindrischen Teils 33 der mit dem Flansch 31 am Flansch 36 anliegenden Federhülse 30 eine Ausnehmung 34 und die Federhülse 30 eine Ausnehmung 32 auf, in welcher eine Druckfeder 65 sowie die Isolierhülse 50 angeordnet sind.

In der Isolierhülse 50 und in dem einen Ende der Federhülse 30 ist der Stößel 55 gelagert, welcher auf der einen Seite ein erstes, mit nicht näher dargestellten Befestigungsmitteln gehaltenes Kontaktorgan 56 aufweist und auf der gegenüberliegenden Seite zur Aufnahme einer durch die im Boden 21 vorgesehene Öffnung 26' hindurchgeführten und als elektrischer Anschluß vorgesehenen Kontakt-Schiene 70 ausgebildet ist. An der Kupplungshülse 35 ist eine weitere, durch die im Boden 21 vorgesehene Öffnung 26 hindurchgeführte und als elektrischer Anschluß vorgesehene Kontakt-Schiene 71 mit nicht näher dargestellten Mitteln gehalten.

Zwischen dem Flansch 6 des Buchsenteils 5 und der Schulter 42 des eine Einheit bildenden Kupplungsstückes 100 ist vorzugsweise eine elastische Dichtung 60 angeordnet.

Beim Zusammenbau wird das Kupplungsstück 100 in das Buchsenteil 5 eingesteckt, und zwar derart, daß die am Stößel 55 befestigte, als erstes Kontaktorgan 56 dienende Scheibe an den Kontakt-Flächen 17, 17' anliegt und die Kupplungshülse 35 mit den zweiten Kontaktorganen 39, 39' bajonettartig hinter die Kontakte 15, 15' greift. Durch die Kraft der sich mit dem einen Ende an der Isolierhülse 50 und mit dem anderen Ende in der Ausnehmung 32 der Federhülse 30 abstützenden Feder 65 wird einerseits der Stößel 55 mit dem ersten Kontaktorgan 56 satt anliegend gegen die Kontakt-Flächen 17, 17' und andererseits die miteinander wirkverbundenen Teile 20, 30, 35 und 40 mit den zweiten Kontaktorganen 39, 39' gegen die Kontaktflächen 18, 18' der Kontaktelemente 15, 15' gepreßt, so daß eine optimale Kontaktierung zwischen den entsprechenden Teilen gewährleistet ist. Ferner werden beim Zusammenbau die Kontaktflächen der Kontaktelemente 15, 15' und 16, 16' sowie der Kontaktorgane 39, 39' und 56 durch die Drehbewegung von eventuellen Verunreinigungen gereinigt und somit eine optimale Kontaktierung der Kontaktstellen gewährleistet. Die Wirkverbindung der Teile 30, 35 und 40 mit dem Kopfstück 20 erfolgt derart, daß die in der Ausnehmung 24 zentrierten Teile 36 und 41 der Kupplungshülse 35 und Haube 40 mit nicht dargestellten Mitteln, beispielsweise durch eine Schraub- oder Klebverbindung mit dem Kopfstück 20 lösbar oder aber fest verbunden sind.

In Fig. 4 ist das Kopfstück 20 im Schnitt gemäß der Linie IV-IV in Fig. 3 in der Draufsicht dargestellt, und man erkennt die beiden durch den Steg 22 voneinander getrennten Ausnehmungen 23, 23' sowie die in den Ausnehmungen angeordneten und durch die im Boden 21 des Kopfstückes vorgesehenen Öffnungen 26, 26' hindurchgeführten elektrischen Anschlüsse 70, 71.

## Patentansprüche

1. Elektrisches Kupplungsstück, welches ein erstes (56) und ein zweites Kontaktorgan (39; 39') aufweist und in ein mit im Abstand zueinander angeordneten Kontaktelementen versehenes Buchsenteil (5) eines Sicherungshalters einsteck- und arretierbar ist, wobei in gekuppeltem Zustand die Kontaktorgane (56; 39; 39') des Kupplungsstückes die zugeordneten Kontaktelemente (16; 16'; 15; 15') des Buchsenteils kontaktieren, dadurch gekennzeichnet, daß das erste Kontaktorgan (56) für die ersten Kontaktelemente (16, 16') an dem einen Ende eines in dem Kupplungsstück (100) koaxial angeordneten Stößel (55) befestigt ist, daß mehrere zweite Kontaktorgane vorhanden sind und die zweiten Kontaktorgane (39, 39') für die zweiten Kontaktelemente (15, 15') an dem einen Ende einer durch eine Isolierhülse (50) von dem Stößel (55) getrennten Kupplungshülse (35) angeformt sind, daß die Kontaktorgane (56, 39, 39') durch die Kraft einer einzigen Druckfeder (65) gegen die zugeordneten Kontaktelemente (16, 16', 15, 15') gepreßt werden, und daß am jeweiligen anderen Ende des Stößels (55) und der Kupplungshülse (35) mindestens ein jeweils in einer Ausnehmung (23, 23') eines Kopfstückes (20) angeordneter elektrischer Anschluß (70, 71) befestigt ist.

2. Elektrisches Kupplungsstück nach Anspruch 1, dadurch gekennzeichnet, daß die genannten zweiten Kontaktorgane (39, 39') aus mindestens zwei gleichmäßig am Umfang der Kupplungshülse (35) verteilt angeordneten Kontakt- und Haltenocken bestehen, und daß die Kupplungshülse (35) am genannten anderen Ende einen Flansch (36) aufweist, welcher in einer Ausnehmung (24) des Kopfstückes (20) zentriert ist.

3. Elektrisches Kupplungsstück nach Anspruch 1, dadurch gekennzeichnet, daß die mit dem einen Ende an der Isolierhülse (50) anliegende Druckfeder (65) mit dem anderen Ende in einer Ausnehmung (32) einer isolierten Federhülse (30) angeordnet ist, wobei die Federhülse (30) mit einem Flanschteil (31) an einem Steg (25) des Kopfstückes (20) anliegt und mit einem zylindrischen Teil (33) in einer Ausnehmung (34) der Kupplungshülse (35) zentriert ist.

4. Elektrisches Kupplungsstück nach Anspruch 1, dadurch gekennzeichnet, daß der Stößel (55) mit der Isolierhülse (50) in der Federhülse (30) zentriert und axial verschiebbar geführt ist, und daß die Federhülse (30) in der Kupplungshülse (35) und die Kupplungshülse in einer mit dem Kopfstück (20) wirkverbundenen Haube (40) zentriert ist.

5. Elektrisches Kupplungsstück nach Anspruch 1, dadurch gekennzeichnet, daß das Kupplungsstück (100) als eine Baueinheit ausgebildet ist, und daß in eingestecktem und verriegeltem Zustand zwischen einer Schulter (42) der Haube (40) und einem Flansch (6) des Buchsenteils (5) eine Dichtung (60) angeordnet ist.

## Claims

1. Electrical coupling which has a first (56) and a second contact part (39, 39') and which can be inserted into, and retained in, a sleeve part (5) of a fuseholder provided with contact elements arranged at a distance from each other, whereby in the coupled state the contact parts (56, 39, 39') of the coupling contact the associated contact elements (16, 16', 15, 15') of the sleeve part, characterised in that the first contact part (56) for the first contact elements (16, 16') is secured at the one end of a push rod (55) arranged coaxially in the coupling (100), that a plurality of second contact parts are present and the second contact parts (39, 39') for the second contact elements (15, 15') are formed at the one end of a coupling sleeve (35) separated by an insulating sleeve (50) from the push rod (55), that the contact parts (56, 39, 39') are arranged to be pressed against the associated contact elements (16, 16', 15, 15') by the force of a single pressure spring (65), and that at the respective other end of the push rod (55) and the coupling sleeve (35) there is secured at least one electrical terminal (70, 71) arranged in a recess (23, 23') of a head piece (20).

2. Electrical coupling according to claim 1, characterised in that said second contact parts (39, 39') comprise at least two contact- and retaining projections uniformly distributed on the periphery of the coupling sleeve (35), and that the coupling sleeve (35) has at the said other end a flange (36) which is centred in a recess (24) of the head piece (20).

3. Electrical coupling according to claim 1, characterised in that the pressure spring (65) abutting with the one end against the insulating sleeve (50) is arranged with the other end in a recess (32) of an insulated spring sleeve (30), whereby the spring sleeve (30) abuts by a flange part (31) against a crosspiece (25) of the head piece (20) and is centred by a cylindrical part (33) in a recess (34) of the coupling sleeve (35).

4. Electrical coupling according to claim 1, characterised in that the push rod (55) is centred with the insulating sleeve (50) in the spring sleeve (30) and is guided in an axially displaceable manner, and that the spring sleeve (30) and is guided in an axially displaceable manner, and that the spring sleeve (30) is centred in the coupling sleeve (35) and the coupling sleeve is centred in a cap (40) operatively connected to the head piece (20).

5. Electrical coupling according to claim 1, characterised in that the coupling (100) is constructed as a unit and that in the inserted and retained state a packing (60) is arranged between a shoulder (42) of the cap (40) and a flange (6) of the sleeve part (5).

## Revendications

1. Raccord de branchement électrique qui comporte un premier et un second organes de contact, qui est destiné à être enfiché et immobilisé dans une douille d'un dispositif de fusibles de sécurité, laquelle est pourvue d'éléments de contact espacés l'un de l'autre, de telle sorte que à l'état accouplé, les organes de contact (56, 39, 39') du raccord de branchement soient en contact avec les éléments de contact correspondants (16, 16', 15, 15') de la douille (5), raccord caractérisé en ce que le premier organe de contact (56) pour les premiers éléments de contact (16, 16') est fixé à l'une des extrémités d'un poussoir (55) monté coaxialement dans le raccord de branchement (100), plusieurs organes de contact (39, 39') pour les seconds éléments de contact (15, 15') sont formés à une extrémité d'une douille d'accouplement (35) séparée du poussoir (55) par un manchon isolant (50), les organes de contact (56, 39, 39') étant pressés par la force d'un ressort de compression unique (65) contre les éléments de contact (16, 16', 15, 15') correspondants, tandis qu'à chaque autre extrémité du poussoir (55) et de la douille d'accouplement (35), est fixé au moins un branchement électrique (70, 71) disposé dans un évidement (23, 23') d'une pièce de tête (20).

2. Raccord de branchement électrique suivant la revendication 1, caractérisé en ce que les seconds organes de contact (39, 39') consistent en bossages de contact et de maintien, au moins au nombre de deux, et répartis sur le pourtour de la douille d'accouplement (35), cette douille présentant à l'autre extrémité, une bride (36) qui est centrée dans un évidement (24) de la pièce de tête (20).

3. Raccord de branchement électrique suivant la evendication 1, caractérisé en ce que le raccord de compression (65) qui est appliqué, par une extrémité contre le manchon isolant (50), est disposé avec son autre extrémité, dans un évidement (32) d'un manchon à ressort isolant (30), ce manchon étant appliqué avec une partie de bride (31) contre une partie pleine (25) de la pièce de tête (20), et est centré, avec une partie cylindrique (33) dans un évidement (34) de la douille d'accouplement (35).

4. Raccord de branchement électrique suivant la revendication 1, caractérisé en ce que le poussoir (55) avec le manchon isolant (50) est centré et guidé à coulissement axial dans le manchon de ressort (30), ce dernier étant lui-même centré dans la douille d'accouplement (35), et celleci étant centrée dans un capot (40) coopérant avec la pièce de tête (20).

5. Raccord de branchement électrique suivant la revendication 1, caractérisé en ce que ce raccord (100) est constitué comme une unité de construction, avec à l'état enfiché et verrouillé, une garniture d'étanchéité (60) disposée entre un épaulement (42) du capot (40) et une bride (6) de la partie de douille (5).

## FIG. 1

## FIG. 3

## FIG. 2

## FIG. 4